(19) **Europäisches Patentamt**
**European Patent Office**
**Office européen des brevets**

(11) **EP 1 462 233 A1**

(12) **EUROPEAN PATENT APPLICATION**
published in accordance with Art. 158(3) EPC

(43) Date of publication:
**29.09.2004 Bulletin 2004/40**

(51) Int Cl.7: **B29C 43/20**, B29C 43/32

(21) Application number: **02802695.3**

(22) Date of filing: **25.09.2002**

(86) International application number:
**PCT/JP2002/010024**

(87) International publication number:
**WO 2003/039832 (15.05.2003 Gazette 2003/20)**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **09.11.2001 JP 2001344934**

(71) Applicant: **Yamauchi Corporation
Hirakata-shi, Osaka 573-1132 (JP)**

(72) Inventor: **YOSHIDA, Akira
Hirakata-shi, Osaka 573-1132 (JP)**

(74) Representative: **Hoffmann, Jörg Peter, Dr. Ing.
Müller Hoffmann & Partner
Patentanwälte
Innere Wiener Strasse 17
81667 München (DE)**

(54) **CUSHIONING MATERIAL FOR HOT PRESSING AND PROCESS FOR PRODUCING LAYERED BOARD**

(57)     A cushioning pad fur hot pressing has a non-woven fabric made of a mixed fiber of a fiber A and a fiber B in order to improve the cushion property and the thermal conductivity thereof. Fiber A is an aromatic polyamide fiber, and fiber B is a fiber having a thermal conductivity of 10 W/(m·K) or more in its length direction, a decomposition starting temperature of 350°C or more, a resistance of incipient tension of 1000 g/d or more, and a specific electric resistance of $10^{10}$ Ω·cm or more.

FIG. 1

## EP 1 462 233 A1

**Description**

Technical Field

This invention relates to a cushioning pad for hot pressing, and a production method of a laminate. More specifically, this invention relates to a cushioning pad for hot pressing which is used when an object product is subjected to pressing or thermocompression bonding in the process of producing a precision instrument component having a lamination structure, such as a printed circuit board including a copper-clad laminate, a flexible printed circuit board, a multilayer lamination board and so on, an IC card, a liquid crystal display panel, and a ceramic lamination board (hereinafter, referred to as a "laminate" in the present invention), and a production method of a laminate using the cushioning pad.

Background Art

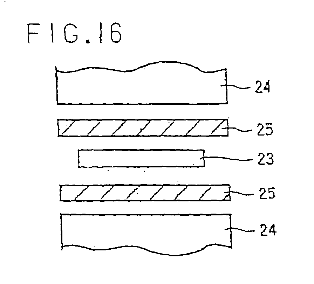

In the production of a laminate such as a printed circuit board, there is used a method of sandwiching a laminate material 23, which is an object to be pressed, between hot plates 24 and 24 as shown in Fig. 16 and, then, applying a predetermined pressure and heat thereto in the process of pressing or thermocompression bonding. In order to obtain a molded product with high precision, it is necessary to make the heat and pressure applied to laminate material 23 uniform over the whole of the surface thereof in the hot pressing. For such a purpose, the hot pressing is performed in the state where a planar cushioning pad 25 is interposed between hot plates 24 and laminate material 23.
As cushioning pad 25 for hot pressing, there are used various kinds of materials, such as kraft paper, organic or inorganic fibers bonded with a binder, rubber, nonwoven fabric, and a laminate made of rubber and nonwoven fabric. Basically, the materials other than kraft paper are repeatedly used for a plurality of pressings. Cushioning pad 25 wherein nonwoven fabric is used is particularly superior in the performance of absorbing thickness unevenness of the hot plates and a laminate inside press. Therefore, cushioning pad 25 is particularly suitable for a case where it is necessary to apply uniform pressurizing force to the whole face of laminate material 23 in press forming of a laminate for which plate-thickness precision is required or a laminate having irregularities.
Since heat resistance is required for any cushioning p ad for hot pressing, hitherto aromatic polyamide fiber has been generally used as fibrous material for a cushioning pad using nonwoven fabric. Japanese Patent Laying-Open No. 55-101224 as a known literature describes a multilayered needle felt cushioning pad made of aromatic polyamide fiber. The same publication describes that fluorocarbon fiber, glass fiber, metal fiber, carbon fiber or the like may be mixed with the aromatic polyamide fiber.
Laminates such as a printed circuit board have a tendency that they have been made minuter year by year. For this reason, improvement in cushion property is required for cushioning pads for hot pressing used when laminates are produced. At the same time, in order to make the production of laminates efficient, it is necessary to shorten the time required for the pressing. Therefore, improvement in thermal conductivity is also required for the cushioning pads.
However, if the unit area weight (thickness) of nonwoven fabric is made large to make the cushion property of a cushioning pad high, the thermal conductivity deteriorates. If importance is attached to the thermal conductivity thereof to make the unit area weight of nonwoven fabric small, the cushion property deteriorates. As described above, improvement in the cushion property and improvement in the thermal conductivity are incompatible requirements. In recent stream of making laminates minute and making the production of the laminates efficient, two requirements of the improvement in the cushion property and the improvement in the thermal conductivity cannot be simultaneously satisfied in any known cushioning pad made of nonwoven fabric.
Thus, an object of this invention is to provide a cushioning pad for hot pressing which makes it possible to improve both of cushion property and thermal conductivity.
Another object of this invention is to provide a production method of a laminate which makes it possible to produce a minute laminate efficiently by improving both of the cushion property and the thermal conductivity of a cushioning pad for hot pressing.

Disclosure of the Invention

The present inventor tried to solve the above-mentioned problems by making nonwoven fabric used in a cushioning pad for hot pressing to mixed nonwoven fabric wherein an aromatic polyamide fiber is mixed with another fiber. As described in the above-mentioned Japanese Patent Laying-Open No. 55-101224, trials wherein an aromatic polyamide fiber is mixed with another fiber have been conventionally made as nonwoven fabric used in a cushioning p ad for hot pressing. However, no cushioning pads for hot pressing satisfying incompatible requests of improvement in cushion property and improvement in thermal conductivity at the same time have been obtained from any known mixed nonwoven fabric.

The present inventor made eager researches repeatedly. As a result, the present inventor has found out that improvement in the cushion property and improvement in the thermal conductivity can be simultaneously attained by mixing a specified fiber with an aromatic polyamide fiber.

That is, in one aspect, a cushioning pad for hot pressing according to this invention includes a nonwoven fabric made of a mixed fiber of the following fiber A and the following fiber B:

fiber A: an aromatic polyamide fiber, and
fiber B: a fiber having a thermal conductivity of 10 W/(m·K) or more in its length direction, a decomposition starting temperature of 350°C or more, a resistance of incipient tension of 1000 g/d or more, and a specific electric resistance of $10^{10}$ Ω·cm or more.

In another aspect, a cushioning pad for hot pressing according to this invention includes a nonwoven fabric made of a mixed fiber of the following fiber A and the following fiber B:

fiber A: an aromatic polyamide fiber, and
fiber B: a polybenzazole fiber.

By making a cushioning pad for hot pressing into a structure having nonwoven fabric made of the mixed fiber of fiber A and fiber B, both of the cushion property and thermal conductivity of the cushioning p ad for hot pressing are improved.

In order to improve the cushion property and the thermal conductivity, the blend ratio of fiber A to fiber B (fiber A/fiber B), which is represented as a weight fraction, is preferably set to 95/5 to 55/45.

Preferably, the nonwoven fabric is obtained by laminating the mixed fibers on and beneath a base fabric and integrating the resultant by needle punch. By applying the needle punch, the fibers constituting the web, in particular, fiber B having a high thermal conductivity can be oriented in the thickness direction of the cushioning pad; therefore, the thermal conductivity of the cushioning pad can be effectively improved.

In order to improve the thermal conductivity of the cushioning pad and further make an change amount in the cushion property with the passage of time small, the nonwoven fabric is preferably subjected to compression treatment in advance, so that the unit area weight per millimeter in thickness is 350 g/(m²·mm) to 1500 g/(m²·mm).

In one example, the cushioning pad has a structure wherein two or more layers of the nonwoven fabric are bonded to each other. In another example, the cushioning pad has a lamination structure of three or more layers, the nonwoven fabric is positioned between the surface layer and the rear layer, and fibers positioned in the surface and the rear face of the nonwoven fabric are fixed by layers contacting the surface and the rear face. In this case, for example, the cushioning pad includes a rubber layer between the surface layer and the rear face layer. The surface layer and the rear face layer are selected from the group consisting of films, woven fabrics, papers, foils, sheets and plates.

In one aspect, a production method of a laminate according to this invention includes interposing a cushioning pad between a laminate material and heating/pressurizing means, and heat-treating/press-treating the laminate in this state, wherein the cushioning pad includes a nonwoven fabric made of a mixed fiber of the following fiber A and the following fiber B:

fiber A: an aromatic polyamide fiber, and
fiber B: a fiber having a thermal conductivity of 10 W/(m·K) or more in its length direction, a decomposition starting temperature of 350°C or more, a resistance of incipient tension of 1000 g/d or more, and a specific electric resistance of $10^{10}$ Ω·cm or more.

In another aspect, a production method of a laminate according to this invention includes interposing a cushioning pad between a laminate material and heating/pressurizing means, and heat-treating/press-treating the laminate in this state, wherein the cushioning pad includes a nonwoven fabric made of a mixed fiber of the following fiber A and the following fiber B:

fiber A: an aromatic polyamide fiber, and
fiber B: a polybenzazole fiber.

By making a cushioning pad for hot pressing into a structure having nonwoven fabric made of the mixed fiber of fiber A and fiber B, both of the cushion property and thermal conductivity of the cushioning pad for hot pressing are improved. The improvement in the cushion property of the cushioning pad makes it possible to produce a minute laminate, and the improvement in the thermal conductivity of the cushioning pad makes it possible to shorten pressing time and produce a laminate efficiently.

Brief Description of the Drawings

Fig. 1 is a sectional view showing an example of a cushioning pad for hot pressing according to the present invention.
Fig. 2 is a sectional view showing another example of a cushioning pad for hot pressing according to the present invention.
Fig. 3 is a sectional view showing still another example of a cushioning pad for hot pressing according to the present invention.
Fig. 4 is a sectional view showing yet another example of a cushioning pad for hot pressing according to the present invention.
Fig. 5 is a sectional view showing yet another example of a cushioning pad for hot pressing according to the present invention.
Fig. 6 is a sectional view showing yet another example of a cushioning pad for hot pressing according to the present invention.
Fig. 7 is a sectional view showing yet another example of a cushioning pad for hot pressing according to the present invention.
Fig. 8 is a sectional view showing yet another example of a cushioning pad for hot pressing according to the present invention.
Fig. 9 is a sectional view showing yet another example of a cushioning pad for hot pressing according to the present invention.
Fig. 10 is a sectional view showing yet another example of a cushioning pad for hot pressing according to the present invention.
Fig. 11 is a sectional view showing yet another example of a cushioning pad for hot pressing according to the present invention.
Fig. 12 is a sectional view showing yet another example of a cushioning pad for hot pressing according to the present invention.
Fig. 13 is a sectional view schematically showing a hot pressing apparatus used in a production method of a laminate according to the present invention.
Fig. 14 is a sectional view schematically showing a tester for measuring heat resistance.
Fig. 15 is a sectional view schematically showing a tester for measuring cushion property.
Fig. 16 is a sectional view schematically showing a conventional hot pressing apparatus.

Best Modes for Carrying Out the Invention

Hereinafter, examples of the present invention will be described with reference to the drawings.

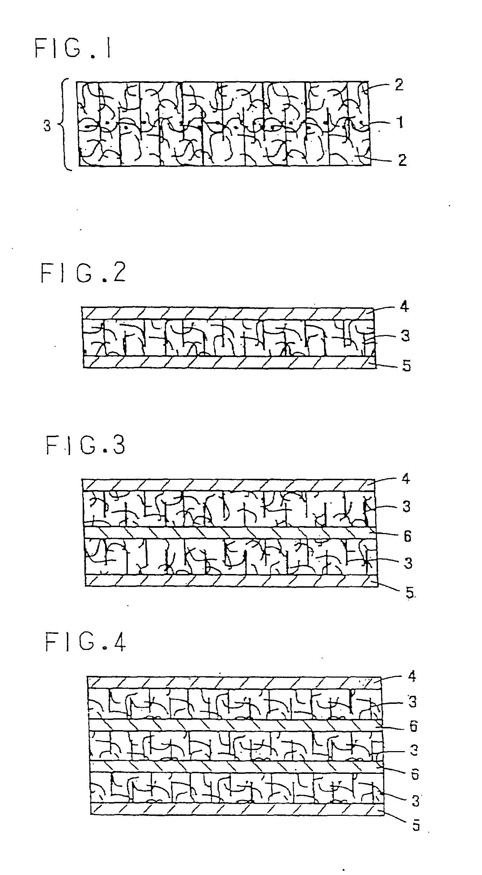

Figs. 1 to 12 show examples of a cushioning pad for hot pressing according to the present invention. All of the cushioning pad have a nonwoven fabric obtained by laminating webs 2 on the upper and lower faces of a base fabric 1 and integrating them by needle punch. In Figs. 2 to 12, base fabric 1 in a nonwoven fabric layer 3 is not shown.
In nonwoven fabric (layer) 3, webs 2 are fiber-collected bodies made of a mixed fiber of an aromatic polyamide fiber (fiber A) and a fiber (fiber B) having predetermined physical properties. Fiber B needs to satisfy the following requirements: a thermal conductivity of 10 W/(m·K) or more in a length direction; a decomposition starting temperature of 350°C or more; a resistance of incipient tension of 1000 g/d or more; and a specific electric resistance of $10^{10}$ Ω·cm or more.
By mixing the fiber having a high thermal conductivity of 10 W/(m·K) or more in the length direction with the aromatic polyamide fiber, the thermal conductivity of the cushioning pad for hot pressing is improved. Herein, the thermal conductivity of fiber B in the length direction can be measured by, for example, a method shown in Jpn. J. Appl. Phys., 36, 5633 (1997). However, the thermal conductivity may be measured by any known method other than this.
Since the cushioning pad for hot pressing is repeatedly used under heating, heat resistance is required. For this purpose, the fiber mixed with the aromatic polyamide fiber needs to have a decomposition starting temperature of 350°C or more. If the heat resistance of the fiber mixed with the aromatic polyamide fiber is low, there is a possibility that this fiber decomposes thermally while the cushioning pad is repeatedly used for hot pressing. When the fiber decomposes thermally, the following problems are caused: physical properties of the cushioning pad drops; the fiber itself is damaged; and components of the fiber leaks as bleed material or gas outside the cushioning pad so as to contaminate a product to be pressed or the environment of the surrounding. The aromatic polyamide fiber (fiber A) has no melting point, and the thermal decomposition temperature thereof is generally from about 400°C to 550°C. In addition to this, the decomposition starting temperature of the fiber (fiber B) mixed with the aromatic polyamide fiber is also set to 350°C or more, whereby the cushioning pad can be obtained having the nonwoven fabric wherein these fibers are mixed whose cushion property and other physical properties do not fall over a long time. The decomposition starting temperature can be measured by the thermo-gravimetry method prescribed in JIS K7120.

By mixing the fiber having a high resistance of incipient tension of 1000 g/d or more with the aromatic polyamide fiber, the cushioning pad for hot pressing is made up to a cushioning pad which is relatively bulky in a non-pressurized state, has a large amount of change in the thickness in a pressurized state, and has a superior recovery property of the thickness when the pressurization is cancelled. That is, the cushion property of the cushioning pad is improved. The resistance of incipient tension can be measured by the method prescribed in JIS L1013.

The fibrous material of the nonwoven fabric constituting the cushioning pad for hot pressing needs to be electrically insulating fiber. The reason for this is as follows: in laminates such as a printed circuit board, minute circuits are generally formed on an electrically insulating substrate; therefore, if electrically conductive fiber is used in a cushioning pad and the fiber is incorporated into the laminate for some cause, a fatal defect for the laminate is caused. For this reason, the fiber mixed with the aromatic polyamide fiber is made to an insulating fiber having a specific electric resistance of $10^{10}$ Ω·cm or more. In light of this, electrically conductive fiber, such as metal fiber or carbon fiber, cannot be used.

The fiber having all the above-mentioned physical properties, as fiber B, may be polybenzazole (PBZ). Examples of the PBZ fiber include polyparaphenylene benzobisoxazole (PBO) fiber, polyparaphenylene benzobisthiazole (PBT) fiber, or fiber made of random or block copolymer thereof. Among these fibers, PBO fiber is optimal at present. PBO fiber is commercially available as the trade name "ZYLON" from Toyobo Co., Ltd.

By using PBZ fiber or the fiber having all the above-mentioned physical properties as fiber B mixed with the aromatic polyamide fiber, both of the cushion property and the thermal conductivity of the cushioning pad for hot pressing can be improved and the cushioning pad for hot pressing can be made suitable for the production of a laminate.

The blend ratio of fiber A to fiber B (fiber A/fiber B) is preferably set to the range of 95/5 to 55/45, more preferably 90/10 to 55/45. If the ratio of fiber B to fiber A is smaller than this, the effect of the mixture of fiber B is small. On the other hand, if the ratio of fiber B to fiber A is larger than this, the thermal conductivity of the cushioning pad is too large so that heat-buffering effect is poor. As a result, there is a possibility that heat conducted to the molded material becomes uneven.

The cushioning pad is a nonwoven fabric obtained by laminating webs 2 on the upper and lower faces of base fabric 1 and integrating them by needle punch. As base fabric 1, there is suitably used a woven fabric made of heat-resistant fiber such as glass fiber, aromatic polyamide fiber or polybenzazol fiber, or such fiber coated with a heat-resistant adhesive such as fluoro rubber. Base fabric 1 contributes to the dimensional stability of the cushioning pad and base fabric 1 and webs 2 are entangled by the needle punch, whereby even if the cushioning pad is repeatedly used for hot pressing, the shape of the cushioning pad is maintained and the endurance thereof becomes very good. In Fig. 1, base fabric 1 is made of only one layer, but may be two or more layers of fabrics 1 and webs 2 are alternately laminated.

Since the cushioning pad is provided with the needle-punched nonwoven fabric, the following peculiar effects and advantages are brought about in the present invention. That is, by the application of the needle punch, the fiber constituting the webs 2 is oriented in the thickness direction. Fiber B exhibiting a high thermal conductivity of 10 W/(m·K) or more in the length direction is mixed with the webs 2, and fiber B is oriented in the thickness direction by the needle punch, whereby the thermal conductivity of the cushioning pad can be effectively improved. By changing the degree of the needle punch to adjust the orientation degree of the fiber, the thermal conductivity of the cushioning pad can be optimally adjusted.

It is preferred about the nonwoven fabric as the cushioning pad that the unit area weight thereof per mm in thickness is set to 350 g/(m²·mm) to 1500 g/(m²·mm) by subjecting the nonwoven fabric to compression treatment by pressurizing or some other method before the nonwoven fabric is used for the production of a laminate. By subjecting the nonwoven fabric to compression treatment beforehand, the thermal conductivity of the cushioning pad is improved. Additionally, by subjecting the nonwoven fabric to compression treatment beforehand, the amount of permanent set-in fatigue generated in the cushioning pad while the cushioning pad is repeatedly used for the production of a laminate can be made small and the amount of change in the cushion property with the passage of time can be made small.

The descriptions will be given of structures of the respective cushioning pads for hot pressing shown in Figs. 2 to 12. In the respective cushioning pads for hot pressing, the same reference numbers are used for the same materials.

In the cushioning pad for hot pressing shown in Fig. 2, a surface layer 4 and a rear face layer 5 are bonded to both faces of nonwoven fabric layer 3 having the structure shown in Fig. 1. Surface layer 4 and rear face layer 5 are films, woven fabrics, papers, foils, sheets, plates or the like, which are made of heat-resistant organic or inorganic material. An object to which adhesiveness is imparted by an adhesive or the like can be adhered to one face of these materials. As a form of the films, it is allowable to coat both the faces with liquid resin and then harden the resin to form surface layer 4 and rear face layer 5. A particularly preferred example of surface layer 4 and rear face layer 5 is a sheet obtained by applying a fluoro rubber based adhesive to a single face (adhesive face) of a glass cloth substrate and applying polyimide resin to the other face (surface).

In the cushioning pad for hot pressing shown in Fig. 3, two nonwoven fabric layers 3 having the structure shown in Fig. 1 are used and two nonwoven fabric layers 3 and 3 are bonded to each other with an adhesion-reinforcing layer 6. A surface layer 4 and a rear face layer 5 are bonded to the surfaces of upper and lower nonwoven fabric layers 3 and 3, respectively. As adhesion-reinforcing layer 6, there can be used a layer having adhesiveness by an adhesive or the like on both faces of a woven fabric made of heat-resistant fiber such as glass fiber, aromatic polyamide fiber or polybenzazole fiber. An example thereof includes a layer wherein both faces of a glass cloth are coated with a fluoro rubber based adhesive.

In the cushioning pad for hot pressing shown in Fig. 4, three nonwoven fabric layers 3 having the structure shown in Fig. 1 are used, and they are bonded to each other with adhesion-reinforcing layers 6 and 6 being interposed between respective nonwoven fabric layers 3', 3 and 3'. A surface layer 4 and a rear face layer 5 are bonded to the surfaces of upper and lower nonwoven fabric layers 3' and 3', respectively. In the structure shown in Fig. 4, nonwoven fabric layers 3 may be made into four or more layers between which adhesion-reinforcing layers 6 are interposed.

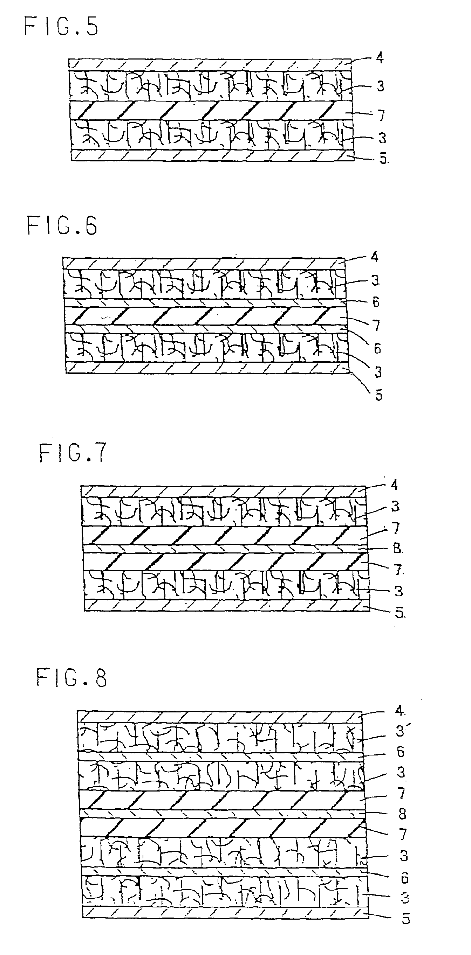

In the cushioning pad for hot pressing shown in Fig. 5, two nonwoven fabric layers 3 having the structure shown in Fig. 1 are used and a rubber layer 7 is interposed between two nonwoven fabric layers 3 and 3. A surface layer 4 and a rear face layer 5 are bonded to the surfaces of upper and lower nonwoven fabric layers 3 and 3, respectively. Rubber layer 7 is bonded to nonwoven fabric layers 3 and 3 by vulcanization of rubber layer 7 without any adhesive layer being interposed therebetween. As the material of rubber layer 7, heat-resistant rubber such as fluoro rubber or EPDM can be used.

In the cushioning pad for hot pressing shown in Fig. 6, two nonwoven fabric layers 3 having the structure shown in Fig. 1 are used and a rubber layer 7 is interposed between two nonwoven fabric layers 3 and 3. A surface layer 4 and a rear face layer 5 are bonded to the surfaces of upper and lower nonwoven fabric layers 3 and 3, respectively. Rubber layer 7 is bonded to nonwoven fabric layers 3 and 3 by interposing adhesion-reinforcing layers 6 and 6 therebetween.

In the cushioning pad for hot pressing shown in Fig. 7, two nonwoven fabric layers 3 having the structure shown in Fig. 1 are used. Between two nonwoven fabric layers 3 and 3 is interposed a lamination structure wherein a reinforcing layer 8 which is a woven fabric made of heat-resistant fiber such as glass fiber, aromatic polyamide fiber or polybenzazole fiber is sandwiched between two rubber layers 7 and 7. Surface layer 4 and rear face layer 5 are bonded to the surfaces of upper and lower nonwoven fabric layers 3 and 3, respectively. Rubber layer 7 is bonded to nonwoven fabric layers 3 and rubber layer 7 is bonded to reinforcing layer 8 by vulcanization of rubber layer 7 without any adhesive layer being interposed therebetween.

In the cushioning pad for hot pressing shown in Fig. 8, four nonwoven fabric layers 3 having the structure shown in Fig. 1 are used. Two upper nonwoven fabric layers 3' and 3 are bonded to each other and two lower nonwoven fabric layers 3 and 3' are bonded to each other by interposing each of adhesion-reinforcing layers 6 therebetween. Between two upper nonwoven fabric layers 3' and 3 and two lower nonwoven fabric layers 3 and 3' is interposed a lamination structure wherein a reinforcing layer 8 is sandwiched between two rubber layers 7 and 7. Surface layer 4 and rear face layer 5 are bonded to the surfaces of upper and lower nonwoven fabric layers 3' and 3', respectively. Rubber layer 7 is bonded to nonwoven fabric layer 3 and rubber layers 7 are bonded to reinforcing layer 8 by vulcanization of rubber layer 7 without any adhesive layer being interposed therebetween.

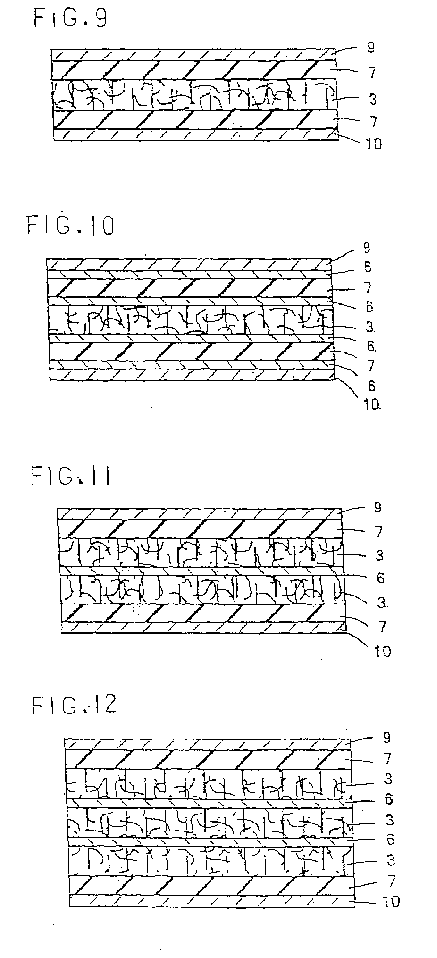

In the cushioning pad for hot pressing shown in Fig. 9, rubber layers 7 and 7 are laminated on the upper and lower faces of nonwoven fabric layer 3 having the structure shown in Fig. 1, and further a surface layer 9 and a rear face layer 10 are laminated on the upper and lower faces thereof. As surface layer 9 and rear face layer 10, there can be used films, woven fabrics, papers, foils, sheets, plates or the like which are made of heat-resistant organic or inorganic material. Rubber layer 7 can be bonded to nonwoven fabric layer 3 and rubber layer 7 can be bonded to surface layer 9 or rear face layer 10 by vulcanization of rubber layer 7 without any adhesive layer being interposed therebetween. Particularly preferred examples of surface layer 9 and rear face layer 10 include fluoro resin films. As surface layer 9 and rear face layer 10, instead of the fluoro resin films, the following can be used: the same materials as in surface layer 4 and rear face layer 5, used in Fig. 2 and the like, that is, sheets wherein a single face (adhesion face) of a glass cloth substrate is coated with a fluoro rubber based adhesive and the other face (surface) is coated with polyimide resin.

In the cushioning pad for hot pressing shown in Fig. 10, rubber layers 7 and 7 are laminated on the upper and lower faces of nonwoven fabric layer 3 having the structure shown in Fig. 1, and further a surface layer 9 and a rear face layer 10 are laminated on the upper and lower faces thereof. Rubber layers 7 and 7 are bonded to nonwoven fabric layer 3 and rubber layers 7 and 7 are bonded to surface layer 9 and rear face layer 10 through adhesion-reinforcing layers 6, 6, 6 and 6.

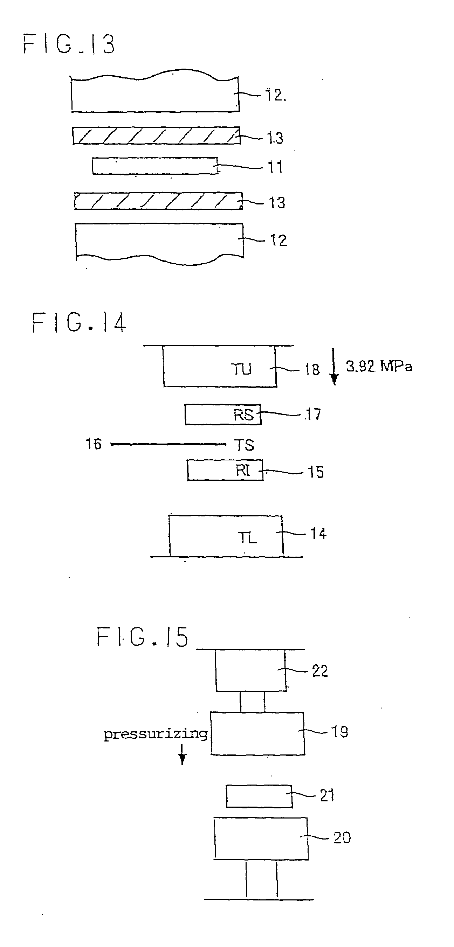

In the cushioning pad for hot pressing shown in Fig. 11, two nonwoven fabric layers 3 having the structure shown in Fig. 1 are used, and two nonwoven fabric layers 3 and 3 are bonded to each other through an adhesion-reinforcing layer 6. Rubber layers 7 and 7 are laminated on the surfaces of upper and lower nonwoven fabric layers 3 and 3, respectively, and further a surface layer 9 and a rear face layer 10 are laminated on the surfaces of upper and lower rubber layers 7 and 7. Rubber layers 7 and 7 can be bonded to nonwoven fabric layers 3 and 3 and rubber layers 7 and 7 can be bonded to surface layer 9 and rear face layer 10 by vulcanization of rubber layers 7 without any adhesive being interposed therebetween.

In the cushioning pad for hot pressing shown in Fig. 12, three nonwoven fabric layers 3 having the structure shown in Fig. 1 are used, and they are bonded to each other with adhesion-reinforcing layers 6 and 6 being interposed between respective nonwoven fabric layers 3', 3 and 3'. Rubber layers 7 and 7 are laminated on the surfaces of upper and lower nonwoven fabric layers 3' and 3', respectively. Furthermore, surface layer 9 and rear face layer 10 are laminated on the surfaces of upper and lower rubber layers 7 and 7. Rubber layers 7 and 7 can be bonded to nonwoven fabric layers 3' and 3', and rubber layers 7 and 7 can be bonded to surface layer 9 and rear face layer 10 by vulcanization of rubber layers 7 without any adhesive layer being interposed therebetween. In the structure shown in Fig. 12, nonwoven fabric layers 3 may be made into four or more layers with another adhesion-reinforcing layer 6 being interposed.

The cushioning pads for hot pressing shown in Figs. 3 to 8, 11 and 12 have a structure wherein two or more nonwoven fabric layers 3 are bonded. That is, nonwoven fabric is divided into a plurality of layers. Therefore, individual nonwoven fabric layers 3 have no permanent set-in fatigue and are superior in dimensional stability. As a result, the whole of the cushioning pad can also suppress problems of permanent set-in fatigue, dimensional change, change in the cushion property with the passage of time, and so forth. In particular, by using a structure wherein two or more nonwoven fabric layers 3 subjected to compression treatment to set the unit area weight per mm in thickness to 350 $g/(m^2 \cdot mm)$ to 1500 $g/(m^2 \cdot mm)$ are bonded, the effect of suppressing permanent set-in fatigue of the cushioning pad, dimensional change thereof, change in the cushion property with the passage of time, and so forth becomes excellent. The blend ratios of fiber A to fiber B or the unit area weights of the respective nonwoven fabric layers may be changed from each other.

All the cushioning p ads for hot pressing shown in Figs. 2 to 12 have a lamination structure of three or more layers, and have a structure wherein nonwoven fabric layer 3 is positioned between surface layer 4 or 9 and rear face layer 5 or 10 and fibers positioned in the surface and the rear face of nonwoven fabric layer 3 are fixed by the layers contacting the surface and the rear face. Therefore, the fibers positioned in the surface of nonwoven fabric layer 3 causes no permanent slip even if the cushioning pad is pressed. As a result, the force for restoring the shape of nonwoven fabric layer 3 becomes excellent. Permanent set-in fatigue of the cushioning pad can be prevented, and even if the cushioning pad is repeatedly used, the cushion property can be maintained.

Furthermore, by fixing the surface of nonwoven fabric layer 3 onto adhesion-reinforcing layer 6, surface layer 4, rear face layer 5 and the like, which are dimensionally stable along the face direction, the dimensional stability of the whole of the cushioning pad is made excellent. The use of the cushioning pad having these characteristics makes it possible to produce stably a laminate having superior quality. By fixing fibers positioned in the surface and the rear face of nonwoven fabric layer 3 by the layers contacting the surface and the rear face, it is possible to prevent the generation of inconveniences in the laminate which is a precision instrument component, caused by feathers of the surface of nonwoven fabric layer 3 or disintegration of fibers from nonwoven fabric layer 3.

All the cushioning pads for hot pressing shown in Figs. 5 to 12 have a structure wherein rubber layer 7 is included between surface layer 4 or 9 and rear face layer 5 or 10. By the inclusion of rubber layer 7, the performance of buffering heat and pressurization force of the cushioning pad is improved so as to improve the performance of making heat and pressurization force conducted to an object to be pressed uniform over the whole of the face. By interposing rubber layer 7 having an appropriate thickness, the thermal conductivity of the cushioning pad can be adjusted. In the cushioning pads for hot pressing shown in Figs. 9, 11 and 12, rubber layer 7 is arranged to contact directly the inside of surface layer 9 and rear face layer 10; therefore, in the case where surface layer 9 and rear face layer 10 are made of synthetic resin films, rubber elasticity can be effectively caused to act on an object to be pressed. Thus, the performance of making heat and pressurization force even and uniform over the whole of the face becomes particularly excellent.

A production method of a laminate according to the present invention will be described. Fig. 13 is a sectional view schematically showing a hot pressing apparatus used in a production method of a laminate according to the present invention. The production of a laminate according to the present invention is performed by interposing cushioning pads 13 and 13 between laminate material 11 and heating/pressurizing means 12 and 12 and subjecting the resultant to heat/pressurizing treatment in this state. Heating/pressurizing means 12 and 12 are generally hot plates, but are not limited thereto. For example, in the case of vacuum press, the heating/pressurizing means is atmospheric pressure. As cushioning pad 13, the cushioning pad for hot pressing according to the present invention, which has been described above in detail, is used. A stiffening plate such as a mirror face plate may be interposed between cushioning pad 13 and laminate material 11. Furthermore, it is allowable to stack a plurality of laminate materials 11 with stiffening plates such as mirror face plates being interposed therebetween, and then hot-press the plurality of laminate materials 11 at a time. In Fig. 13, two cushioning pads 13 are used over and under laminate material 11, but it is allowable to use cushioning pad 13 at only one side of laminate material 11. By using such a hot pressing apparatus and subjecting laminate material 11 to press forming or thermocompression bonding, a laminate can be produced examples of which include printed circuit boards such as a copper-clad laminate, a flexible printed circuit board and a multilayer lamination board, an IC card, a liquid crystal display panel and a ceramic lamination board.

[Examples]

In order to confirm the effects of the present invention, comparison experiments were made as follows. Used fibers were PBO fiber (trade name "ZYLON-AS", manufactured by Toyobo Co., Ltd.), meta-aromatic polyamide fiber (trade name "TEIJINCONEX", manufactured by Teijin Ltd.), and E glass fiber (trade name "Chopped Strand", manufactured by Unitika Glass Fiber Co., Ltd.). Physical properties of the respective fibers are shown in Table 1.

Table 1

|  | PBO fiber | Meta-aromatic polyamide fiber | E glass fiber |
|---|---|---|---|
| Thermal conductivity [W/(m·K)] | 60 | 0.15 | 2.25 |
| Decomposition starting temperature [°C] | 650 | 400 | 850 |
| Resistance of incipient tension [g/d] | 1300 | 140 | - |

[Samples 1 to 5]

As a base fabric of a nonwoven fabric, there was used an adhesive base fabric wherein a glass cloth having an open weave was coated with a fluoro rubber. Webs wherein the meta-aromatic polyamide fiber was mixed with the PBO fiber at each ratio shown in Table 2 were laminated on both faces of this base fabric, and the resultant was subjected to needle punch to prepare a nonwoven fabric. The unit area weight of the resultant nonwoven fabrics was 650 g/m$^2$.

[Samples 6 to 9]

As a base fabric of a nonwoven fabric, there was used an adhesive base fabric wherein a glass cloth having an open weave was coated with a fluoro rubber. Webs wherein the meta-aromatic polyamide fiber was mixed with the E glass fiber at each ratio shown in Table 2 were laminated on both faces of this base fabric, and the resultant was subjected to needle punch to prepare a nonwoven fabric. The unit area weight of the resultant nonwoven fabrics was 650 g/m$^2$.

[Samples 10 to 12]

As a base fabric of a nonwoven fabric, there was used an adhesive base fabric wherein a glass cloth having an open weave was coated with a fluoro rubber. Webs made of the meta-aromatic polyamide fiber were laminated on both faces of this base fabric, and the resultant was subjected to needle punch to prepare a nonwoven fabric. The unit area weight of each of the resultant nonwoven fabrics is as shown in Table 2.

[Test on heat resistance]

With respect to samples 1 to 12, the heat resistance thereof was measured by the following method. As shown in Fig. 14, a lower heating and pressurizing plate (30°C, water-cooled) 14, a heat insulating material (heat resistance 12.55°C/W) 15, a thermocouple 16, and a sample 17 to be evaluated were stacked in this order from the lower side. A pressure of 3.92 MPa was applied to the upper of the resultant by means of an upper heating and pressurizing plate (185°C) 18. The temperature of thermocouple 16 was read.

It is generally known that Ohm's law in heat circuits represented by the following Equation 1 is realized between heat flow (Q), high-temperature section temperature (T1), low-temperature section temperature (T2) and heat resistance (R):

$$Q = (T1 - T2)/R \qquad \text{(Equation 1)}$$

In the present test, when the temperature of upper heating and pressurizing plate 18, the temperature of lower heating and pressurizing plate 14, the temperature of thermocouple 16, the heat resistance of heat insulating material 15 and the heat resistance of sample 17 to be evaluated are represented by TU, TL, TS, RI and RS, respectively, on the basis of Equation 1 heat resistance RS of sample 17 to be evaluated can be obtained as follows:

$$Q = (TU - TL)/(RS + RI) \qquad \text{(Equation 2)}$$

$$Q = (TU - TS)/RS \qquad \text{(Equation 3)}$$

From Equations 2 and 3,

$$RS = (TU - TS)/(TS - TL) \times RI \qquad \text{(Equation 4)}$$

The results of the test are shown in Table 2.

Table 2

| | | Blend ratio | Unit area weight $(g/m^2)$ | Heat resistance $(°C/W)$ | Cushion property $(\mu m)$ |
|---|---|---|---|---|---|
| Sample 1 | Meta-aromatic polyamide fiber/PBO fiber | 95/5 | 650 | 3.24 | 2123 |
| Sample 2 | | 90/10 | 650 | 2.76 | 2397 |
| Sample 3 | | 80/20 | 650 | 2.59 | 2551 |
| Sample 4 | | 55/45 | 650 | 1.90 | 2629 |
| Sample 5 | | 0/100 | 650 | 1.31 | 2718 |
| Sample 6 | Meta-aromatic polyamide fiber/E glass fiber | 95/5 | 650 | 3.41 | |
| Sample 7 | | 90/10 | 650 | 3.34 | |
| Sample 8 | | 80/20 | 650 | 3.21 | |
| Sample 9 | | 55/45 | 650 | 3.03 | |
| Sample 10 | Meta-aromatic polyamide fiber | 100 | 650 | 3.45 | 1556 |
| Sample 11 | | 100 | 550 | 2.69 | 1074 |
| Sample 12 | | 100 | 990 | 4.31 | 2345 |

As is understood from the results, the thermal conductivity of cushioning pads for hot pressing is improved by using nonwoven fabric wherein meta-aromatic polyamide fiber is mixed with PBO fiber. It has been understood that the thermal conductivity is not improved very much even if meta-aromatic polyamide fiber is mixed with glass fiber. If the ratio of PBO fiber is 100%, there is possibility that the thermal conductivity is too good so that the effect of buffering heat is poor.

[Test on cushion property]

Next, respective nonwoven fabrics of samples 1 to 5 and samples 10 to 12 were used to form cushioning pads for hot pressing. A comparison test on the cushion property thereof was performed.

The cushioning pads used in the test were made to have a structure shown in Fig. 3. Herein, as adhesion-reinforcing layer 6, there was used a heat-sensitive adhesion sheet wherein both faces of a glass cloth having a thickness of 0.2 mm were coated with a fluoro rubber in an unvulcanized state. As nonwoven fabric layers 3 and 3 positioned on the upper and lower faces of the adhesive sheet, which is to be adhesion-reinforcing layer 6, the nonwoven fabric of each of the samples was used. As surface layer 4 and rear face layer 5 positioned on and beneath the upper and lower nonwoven fabric layers 3 and 3, there were used heat-sensitive adhesive sheets wherein both faces of a glass cloth having a thickness of 0.2 mm were coated with a fluoro rubber in an unvulcanized state and further polyimide resin was applied to only the surface side so as to give releasing property to the surface side. The respective layers were laminated in the order shown in Fig. 3, and subsequently the resultant was pressed under conditions of 180°C and 1.96 MPa. The fluoro rubbers applied to adhesion-reinforcing layer 6 and surface layer 4, and rear face layer 5 were vulcanized and with that all thereof were bonded and integrated with each other. In the state that the cushioning pad was formed, the unit area weight of each of nonwoven fabric layers 3 was 650 g/m$^2$ and the thickness thereof was 0.9 mm.

With respect to the cushioning pads for hot pressing using the nonwoven fabrics of the respective samples, the cushion property was measured by the following method. As shown in Fig. 15, a sample 21 to be evaluated was sandwiched between an upper heating and pressurizing plate 19 and a lower heating and pressurizing plate 20, and the resultant was pressed under given conditions. At this time, the amount of change in the thickness of sample 21 to be evaluated was read by a pressure sensor 22 positioned over upper heating and pressurizing plate 19. This value was used as cushion amount. About conditions of the press, the range of applied pressure was from $9.81 \times 10^{-4}$ (contact pressure) to 3.92 MPa, and the speed of the applied pressure was 5 mm/min, and the heating temperature was set to 30°C. The results of the test are as shown in Table 2.

As is understood from these results, when the unit area weight of the nonwoven fabric is made large to heighten the cushion property of the cushioning pads in samples 10 to 12 using the 100% meta-aromatic polyamide fiber, the thermal conductivity becomes bad. When importance is attached to the thermal conductivity and the unit area weight of the nonwoven fabric is made small, the cushion property becomes bad. Using the nonwoven fabric wherein the meta-aromatic polyamide fiber is mixed with the PBO fiber, both the thermal conductivity and the cushion property of cushioning pads for hot pressing are improved.

Industrial Applicability

This invention can be suitably applied to a cushioning pad for hot pressing which is used to perform press forming or thermocompression bonding to an object product including a printed circuit board such as a copper-clad laminate, a flexible printed circuit board or a multilayer laminate board, an IC card, a liquid crystal display panel, a ceramic lamination board or the like.

**Claims**

1. A cushioning pad for hot pressing, comprising a nonwoven fabric made of a mixed fiber of the following fiber A and the following fiber B:

   fiber A: an aromatic polyamide fiber, and
   fiber B: a fiber having a thermal conductivity of 10 W/(m·K) or more in its length direction, a decomposition starting temperature of 350°C or more, a resistance of incipient tension of 1000 g/d or more, and a specific electric resistance of $10^{10}$ Ω·cm or more, or a polybenzazole fiber.

2. The cushioning pad for hot pressing according to claim 1, wherein the blend ratio of said fiber A to said fiber B, which is represented as a weight fraction, is 95/5 to 55/45.

3. The cushioning pad for hot pressing according to claim 1, wherein
said nonwoven fabric is obtained by laminating said mixed fibers on and beneath a base fabric and integrating the resultant by needle punch.

4. The cushioning pad for hot pressing according to claim 1, wherein
said nonwoven fabric is subjected to compression treatment so that the unit area weight per millimeter in thickness is 350 g/(m²·mm) to 1500 g/(m²·mm).

5. The cushioning pad for hot pressing according to claim 1, comprising a structure wherein two or more layers of said nonwoven fabric are bonded to each other.

6. The cushioning pad for hot pressing according to claim 1, wherein
said cushioning pad has a lamination structure of three or more layers, said nonwoven fabric is positioned between the surface layer and the rear layer, and fibers positioned in the surface and the rear face of said nonwoven fabric are fixed by layers contacting the surface and the rear face.

7. The cushioning pad for hot pressing according to claim 6, comprising a rubber layer between said surface layer and said rear face layer.

8. The cushioning pad for hot pressing according to claim 6, wherein
said surface layer and said rear face layer are selected from the group consisting of films, woven fabrics, papers, foils, sheets and plates.

9. A production method of a laminate, comprising interposing a cushioning pad between a laminate material and heating/pressurizing means, and heat-treating/press-treating the resultant in this state, wherein
said cushioning pad comprises a nonwoven fabric made of a mixed fiber of the following fiber A and the following fiber B:

fiber A: an aromatic polyamide fiber, and
fiber B: a fiber having a thermal conductivity of 10 W/(m·K) or more in its length direction, a decomposition starting temperature of 350°C or more, a resistance of incipient tension of 1000 g/d or more, and a specific electric resistance of $10^{10}$ $\Omega$·cm or more, or a polybenzazole fiber.

10. The production method of a laminate according to claim 9, wherein
the blend ratio of said fiber A to said fiber B, which is represented as a weight fraction, is 95/5 to 55/45.

11. The production method of a laminate according to claim 9, wherein
said nonwoven fabric is obtained by laminating said mixed fibers on and beneath a base fabric and integrating the resultant by needle punch.

12. The production method of a laminate according to claim 9, wherein
said nonwoven fabric is subjected to compression treatment so that the unit area weight per millimeter in thickness is 350 g/(m²·mm) to 1500 g/(m²·mm).

13. The production method of a laminate according to claim 9, wherein
said cushioning pad has a structure wherein two or more layers of said nonwoven fabric are bonded to each other.

14. The method for producing the laminate according to claim 9, wherein
said cushioning pad has a lamination structure of three or more layers, said nonwoven fabric is positioned between the surface layer and the rear layer, and fibers positioned in the surface and the rear face of said nonwoven fabric are fixed by a layer contacting the surface and the rear face.

15. The production method of a laminate according to claim 14, wherein
said cushioning pad comprises a rubber layer between said surface layer and said rear face layer.

16. The production method of a laminate according to claim 14, wherein
said surface layer and said rear face layer are selected from the group consisting of films, woven fabrics, papers, foils, sheets and plates.

FIG.1

FIG.2

FIG.3

F I G.4

FIG.5

FIG.6

FIG.7

FIG.8

FIG.9

FIG.10

FIG.11

FIG.12

FIG.13

FIG.14

FIG.15

FIG.16

24

25

23

25

24

**EP 1 462 233 A1**

<table>
<tr><td colspan="2" align="center"><strong>INTERNATIONAL SEARCH REPORT</strong></td><td>International application No.<br>PCT/JP02/10024</td></tr>
</table>

A. CLASSIFICATION OF SUBJECT MATTER
Int.Cl⁷ B29C43/20, 43/32

According to International Patent Classification (IPC) or to both national classification and IPC

B. FIELDS SEARCHED

Minimum documentation searched (classification system followed by classification symbols)
Int.Cl⁷ B29C43/18-43/20, 43/32, B32B15/08, D04H1/42-1/58

Documentation searched other than minimum documentation to the extent that such documents are included in the fields searched

| | | | |
|---|---|---|---|
| Jitsuyo Shinan Koho | 1926–1996 | Toroku Jitsuyo Shinan Koho | 1994–2002 |
| Kokai Jitsuyo Shinan Koho | 1971–2002 | Jitsuyo Shinan Toroku Koho | 1996–2002 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| E,X | JP 2002-326302 A (Mitsubishi Gas Chemical Co., Inc.),<br>12 November, 2002 (12.11.02),<br>Claims; Par. Nos. [0001] to [0007]<br>(Family: none) | 1-16 |
| P,X | JP 2002-61057 A (Toyobo Co., Ltd.),<br>28 February, 2002 (28.02.02),<br>Claims; Par. Nos. [0001], [0015] to [0021]<br>(Family: none) | 1-16 |
| A | EP 1030543 A1 (MATSUSITA ELECTRIC INDUSTRIAL CO., LTD.),<br>23 August, 2000 (23.08.00),<br>Claims; Par. Nos. [0001] to [0008]<br>& JP 2000-239995 A | 1-16 |

☐ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>12 December, 2002 (12.12.02) | Date of mailing of the international search report<br>24 December, 2002 (24.12.02) |
|---|---|
| Name and mailing address of the ISA/<br>   Japanese Patent Office | Authorized officer |
| Facsimile No. | Telephone No. |

Form PCT/ISA/210 (second sheet) (July 1998)

19